# EUROPÄISCHE PATENTSCHRIFT

(11) **EP 1 164 670 B1**
(45) Veröffentlichungstag und Bekanntmachung des Hinweises auf die Patenterteilung: **17.08.2005**
(21) Anmeldenummer: 01114386.4
(22) Anmeldetag: 13.06.2001
(51) Int. Cl.: H01S 5/0683, H04B 10/155

(54) **Verfahren und Anordnung zur Regelung modulierter Laser**
Method and device for regulating modulated laser
Procédé et dispositif de régulation de laser modulé

(30) Priorität: 13.06.2000 DE 10029070
(43) Veröffentlichungstag der Anmeldung: 19.12.2001
(73) Patentinhaber: SIEMENS AKTIENGESELLSCHAFT, 80333 München (DE)
(72) Erfinder: Dietrich, Werner, A-1210 Wien (AT); Heiny, Franz, A-7093 Jois (AT)

(56) Entgegenhaltungen:
- US-A- 5 398 008
- US-A- 6 016 326

## Beschreibung

Die Erfindung betrifft ein Verfahren zur Regelung der Ausgangsleistung modulierter Laser,
- bei dem ein Eingangssignal eines Lasers ein Nutzsignal und ein Pilotsignal umfasst und
- bei dem das Pilotsignal zur Regelung der Ausgangsleistung des Lasers herangezogen wird.
Weiterhin betrifft die Erfindung auch eine Anordnung zur Durchführung des Verfahrens.

Modulierte Laser werden beispielsweise für die optische Datenübertragung eingesetzt, und zwar sowohl für die Freiraumdatenübertragung, als auch für die Datenübertragung mittels Lichtwellenleiter. Die Daten werden dabei zum Beispiel nach dem Zeitmultiplexverfahren übermittelt. Bei diesem Verfahren werden mehrere Einzelkanäle zeitlich versetzt auf einem gemeinsamen Übertragungskanal gesendet.

Bei allen Datenübertragungsverfahren ist es wichtig, dass die Intensität des ausgestrahlten Lichts, die einem digitalen Wert zugeordnet ist, innerhalb eines vorgegebenen Toleranzbereiches liegt. Aufgrund verschiedener Einflüsse, wie zum Beispiel der Betriebstemperatur oder der Alterung der für den Laser verwendeten Komponenten, kann ein konstantes Verhältnis von zugeführter Leistung zu abgegebener Leistung nicht vorausgesetzt werden. Deshalb ist es nötig, ein Regelverfahren anzuwenden, das den Betriebsstrom des Lasers so verändert, dass die Intensität des abgegebenen Lichts in einem definierten Bereich liegt.

Aus der WO 98/43330 "Laser modulation control method and apparatus" vom 17. März 1998 ist es bekannt, dass zu diesem Zweck ein Pilotton auf das Nutzsignal aufmoduliert wird. Dabei ist die Amplitude des Pilottons wesentlich kleiner als die Amplitude des Nutzsignals. Weiterhin ist auch die Frequenz des Pilottons wesentlich kleiner als die Frequenz des Nutzsignals. Das vom Laser ausgestrahlte Licht wird von einer Monitordiode empfangen und der durch den Pilotton begründete Anteil des Signals für die Regelung der Laserleistung herangezogen. Auf diese Weise kann die mittlere optische Ausgangsleistung des Lasers und die Amplitude der Ausgangsleistung konstant gehalten werden. Daraus folgt, dass die Intensität des ausgestrahlten Lichts, die einem digitalen Wert zugeordnet ist, konstant ist.

Da der Pilotton im Vergleich zum Nutzsignal eine vergleichsweise kleine Amplitude aufweist, kann die Auswertung erheblich gestört werden, sofern die Frequenz des Pilottons mit einer bedeutenden Spektrallinie des Frequenzspektrums des Nutzsignals übereinstimmt. Durch geeignete Wahl der Frequenz des Pilottons kann dieses Problem vermieden werden. Eine solche Frequenz kann bei bekanntem Frequenzspektrum des Nutzsignals im allgemeinen ermittelt werden.

Moderne Übertragungssysteme werden allerdings unter verschiedensten Randbedingungen eingesetzt. Beispielsweise ist die Übertragungsrate nicht vordefiniert, sondern wird den aktuellen Bedürfnissen angepasst. Des weiteren werden auch unterschiedliche Datenformate zur optischen Datenübertragung herangezogen. Diese Umstände erschweren die Ermittlung einer geeigneten Frequenz für den Pilotton, oder machen diese bei fehlender oder mangelnder Kenntnis des Nutzsignals überhaupt unmöglich.

Die Aufgabe der Erfindung ist es daher, ein Verfahren und eine Anordnung anzugeben, welche die Regelung modulierter Laser vereinfachen.

Dies geschieht erfindungsgemäß mit einem Verfahren der eingangs erwähnten Art, bei dem das Frequenzspektrum des Pilotsignals innerhalb des Frequenzbereichs des Nutzsignals weitgehend gleichverteilt ist.

Durch die Anwendung eines solchen Pilotsignals kann das Problem der Beeinflussung durch einzelne Spektrallinien des Nutzsignals auf besonders einfache Weise weitgehend beseitigt werden. Nur die Signalanteile des vom Empfangselement empfangenen Summensignals, die auf das Pilotsignal zurückzuführen sind, ergeben dabei einen wesentlichen Beitrag zum Signal, das für die Regelung des Lasers herangezogen wird. Aus diesem Signalanteil wird dazu beispielsweise ein äquivalentes Maß für die Pilottonamplitude ermittelt. Eine Trennung des Eingangssignals in Nutzsignal und Pilotsignal kann dabei zum Beispiel mit Korrelationstechniken erreicht werden. Durch Wahl eines geeigneten Pilotsignals sollte die Kreuzkorrelation zwischen Nutzsignal und Pilotsignal jedenfalls möglichst gering gehalten werden. Eine solche Signalfolge ist beispielsweise eine Pseudorauschsequenz.

Derartige Verfahren, die eine gegenseitige Beeinflussung von Signalen durch Verbreiterung der zugeordneten Frequenzspektren verringern, sind auch unter dem Begriff "Spread Spectrum Systeme" bekannt.

Günstig ist es, wenn die Amplitude des Pilotsignals wesentlich kleiner ist, als die Amplitude des Nutzsignals. Auf diese Weise wird die optische Übertragung des im Eingangssignal enthaltenen Nutzsignals durch das zusätzlich enthaltene Pilotsignal vergleichsweise wenig beeinflusst.

Eine besonders vorteilhafte Ausgestaltung der Erfindung sieht ein Verfahren vor, bei dem für das Pilotsignal eine digitale Signalfolge vorgesehen ist. Eine solche Signalfolge ist beispielsweise eine Pseudorauschsequenz, welche so gewählt wird, dass sie eine geringe Kreuzkorrelation zum Nutzsignal aufweist. Durch die Verwendung eines Korrelators zur Demodulation kann das Problem der Beeinflussung durch einzelne Spektrallinien des Datensignals weitgehend beseitigt werden. Die Auswertung im Korrelator besteht dabei im Prinzip aus einer Multiplikation des vom Empfangselement empfangenen Signals mit dem Modulationssignal. Nur die Signalanteile, die auf das Pilotsignal zurückzuführen sind, ergeben einen wesentlichen Beitrag zum Signal, das für die Regelung des Lasers herangezogen wird.

Vorteilhaft ist es weiterhin, wenn für das Pilotsignal eine Impulsfolge vorgesehen ist. Impulse weisen ein breites, weitgehend gleichverteiltes Frequenzspektrum auf, weswegen sie sich gut zur Erzeugung eines Pilotsignals eignen.

Eine vorteilhafte Variante der Erfindung ist gegeben, wenn die zeitlichen Abstände zwischen den einzelnen Impulsen pseudozufällig verteilt sind. Auf diese Weise wird eine Korrelation mit dem Nutzsignal nahezu ausgeschlossen. Dieses Verfahren ist auch unter dem Begriff "Time Hopping" bekannt. Um das Pilotsignal aus dem vom Empfangselement empfangenen Summensignal zu erhalten, müssen die zeitlichen Abstände auch beim Empfangselement berücksichtigt werden.

Besonders vorteilhaft ist es, wenn das Pilotsignal mittels rückgekoppelter Schieberegister erzeugt wird. Diese stellen ein erprobtes Mittel zur Herstellung verschiedener digitaler Signalfolgen dar, beispielsweise zur Erzeugung von Pseudorauschsequenzen. Wird das Pilotsignal auf das Nutzsignal aufmoduliert, so werden diese Folgen dabei sowohl für die Modulation des Pilotsignals auf das Nutzsignal, als auch zur Demodulation des vom Empfangselement empfangenen Signals herangezogen. Neben dieser Realisierungsvariante sind prinzipiell auch andere Verfahren aus der Spread Spectrum Technologie bekannt.

Eine günstige Variante der Erfindung ist gegeben, wenn für das Pilotsignal ein analoges Signal, insbesondere ein zumindest abschnittsweise sinusförmiges Signal, vorgesehen wird. Auf diese Weise können beispielsweise bestehende Schaltkreise zur Erzeugung eines Pilottons vorteilhaft weiterverwendet werden. Nach dem Stand der Technik können analoge Signale auch durch digitale Schaltkreise erzeugt werden. Eine scharfe Trennlinie zwischen reiner Digitaltechnik und Analogtechnik kann an dieser Stelle daher nicht gezogen werden.

Günstig ist es auch, wenn die Frequenz des Pilotsignals fortlaufend variiert wird, insbesondere durch sprungförmige Änderung der Frequenz. Sprungförmige Änderungen der Frequenz sind beispielsweise auch unter dem Begriff "Frequency Hopping" bekannt. Durch die Variation der Frequenz kann ein Frequenzspektrum beliebiger Breite erhalten werden. Ein Beispiel hierfür ist ein Wobbelsignal, ein im wesentlichen sinusförmiges Signal, dessen Frequenz fortlaufend und stetig geändert wird. Um das Pilotsignal aus dem vom Empfangselement empfangenen Summensignal zu erhalten, muss die jeweilige momentane Frequenz des Pilotsignals auch beim Empfangselement berücksichtigt werden.

Eine günstige Ausgestaltung der Erfindung ist gegeben,
- wenn aus dem Eingangssignal, insbesondere aus dem Anteil des Nutzsignals, die mittlere Ausgangsleistung des Lasers ermittelt wird,
- wenn aus dem Eingangssignal, insbesondere aus dem Anteil des Pilotsignals, die Steilheit der Laserkennlinie ermittelt wird und
- wenn die einem digitalen Wert zugeordnete Ausgangsleistung des Lasers aufgrund der ermittelten mittleren Ausgangsleistung des Lasers und der Steilheit der Laserkennlinie geregelt wird.
Diese Regelung stellt ein bewährtes Verfahren dar, weswegen bestehende Schaltkreise auf einfache Weise auf die erfindungsgemäße Arbeitsweise umgerüstet werden können.

Die Aufgabe der Erfindung wird auch durch eine Anordnung zur Regelung der Ausgangsleistung modulierter Laser gelöst,
- bei der die Anordnung Mittel zur Erzeugung eines Eingangssignals für einen Laser beinhaltet, wobei das Eingangssignal ein Pilotsignal und ein Nutzsignal umfasst,
- bei der das Frequenzspektrum des Pilotsignals innerhalb des Frequenzbereichs des Nutzsignals weitgehend gleichverteilt ist und
- bei der die Anordnung Mittel zur Regelung des Lasers mittels Pilotsignal umfasst.
Vorteilhaft können bestehende Anordnungen, die zum Beispiel mit sinusförmigen Pilottönen arbeiten, vergleichsweise einfach dahingehend modifiziert werden, dass die Anwendung von Pilotsignalen mit den erfindungsgemäßen Eigenschaften möglich wird. Weder am Laser an sich, noch auf der Übertragungsstrecke oder am Empfangselement sind dazu Änderungen nötig. Sendeseitig müssen lediglich die Baugruppen zur Erzeugung des Pilotsignals, auf der Empfangsseite nur die Baugruppen zur Verarbeitung des empfangenen Signals ausgetauscht oder entsprechend abgeändert werden. Der Regelalgorithmus an sich kann dagegen unverändert belassen werden.

Eine vorteilhafte Variante der Erfindung sieht die Verwendung zumindest eines rückgekoppelten Schieberegisters für die Erzeugung eines Pilotsignals vor. Diese stellen ein erprobtes Mittel zur Herstellung verschiedener digitaler Signalfolgen dar. Werden beispielsweise Pseudorauschsequenzen erzeugt richtet sich die Länge des verwendeten Schieberegisters vor allem nach der zu erzeugenden Digitalfolge.

Günstig ist es, wenn die Anordnung Mittel zur Verarbeitung eines Datenstroms umfasst. Damit wird es möglich zum Beispiel den Ausgang einer datenverarbeitenden Einheit direkt an das Übertragungssystem anzuschließen. Auf diese Weise können besonders kompakte Baugruppen realisiert werden.

Eine besonders vorteilhafte Anordnung ist gegeben,
- wenn die Anordnung ein Empfangselement beinhaltet und
- wenn die Anordnung Mittel zur Demodulation des vom Empfangselement empfangenen Eingangssignals umfasst.
Um das im Eingangssignal enthaltene Pilotsignal vom Nutzsignal zu trennen, werden vorteilhaft Demodulatoren, abgestimmt auf die jeweilig angewandte Modulationstechnik, eingesetzt. Ein Beispiel hierfür ist ein Korrelator, der das Eingangssignal mit dem Pilotsignal multipliziert und so das Pilotsignal vom Nutzsignal weitgehend trennt.

Günstig ist es,
- wenn die Anordnung ein Empfangselement beinhaltet und
- wenn die Anordnung Mittel zur Filterung des vom Empfangselement empfangenen Eingangssignals umfasst, insbesondere Filter mit variabler Filtercharakteristik.
Durch die Verwendung derartige Filter wird die Möglichkeit geschaffen, das Filter optimal an die Frequenz des gesendeten Pilotsignals anzupassen. Wird für das Pilotsignal beispielsweise ein Wobbelsignal vorgesehen, also ein im wesentlichen sinusförmiges Signal, dessen Frequenz fortlaufend und stetig geändert wird, kann so die Filterfrequenz entsprechend der momentanen Frequenz des Pilotsignals angepasst werden.

Die Erfindung wird anhand eines in den Figuren dargestellten Ausführungsbeispiels näher erläutert, welches ein beispielhaftes Verfahren und eine beispielhafte Anordnung zur Regelung eines modulierten Lasers betrifft, wobei für das Pilotsignal eine digitale Pseudorauschsequenz vorgesehen ist.

Es zeigen:
Figur 1: ein Leistungs-Strom-Diagramm von zwei verschiedenen Laserkennlinien;
Figur 2: eine beispielhafte Anordnung zur Durchführung des erfindungsgemäßen Verfahrens.

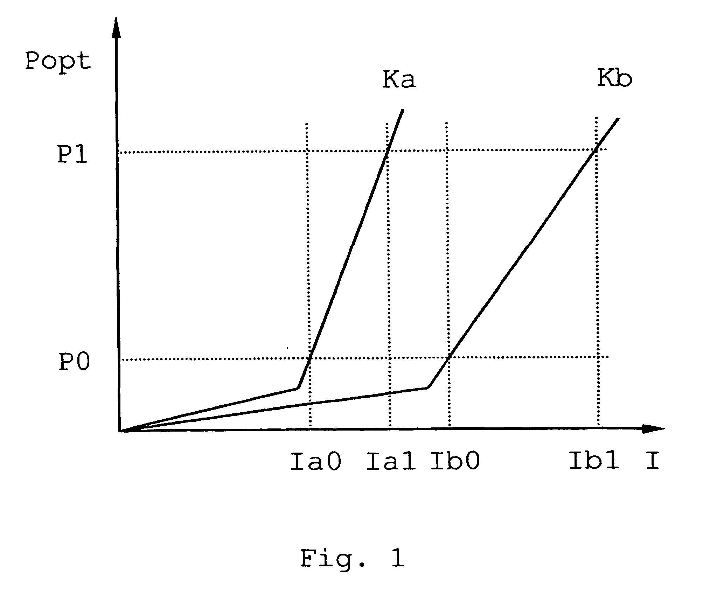

Figur 1 zeigt ein Diagramm mit einer ersten Laserkennlinie Ka und einer zweiten Laserkennlinie Kb, wobei die optische Ausgangsleistung Popt auf der senkrechten Achse, der dem Laser zugeführte Strom I auf der waagrechten Achse aufgetragen ist. Eine erste Ausgangsleistung P0 zeigt die optische Ausgangsleistung des Lasers, die einem digitalen Wert 0 zugeordnet ist. Eine zweite Ausgangsleistung P1 ist analog dazu einem digitalen Wert 1 zugeordnet. Des weiteren ist in das Diagramm ein erster Strom Ia0 eingetragen, der den der ersten Ausgangsleistung P0 zugeordneten Strom auf der ersten Laserkennlinie Ka zeigt. Ein zweiter Strom Ia1 zeigt den der zweiten Ausgangsleistung P1 zugeordneten Strom auf der ersten Laserkennlinie Ka. Analog dazu ist ein dritter Strom Ib0 der ersten Ausgangsleistung P0 auf der zweiten Laserkennlinie Kb und ein vierter Strom Ib1 der zweiten Ausgangsleistung P1 auf der zweiten Laserkennlinie Kb zugeordnet.

Die erste Laserkennlinie Ka und die zweite Laserkennlinie Kb zeigen das Verhalten des Lasers bei verschiedenen Betriebszuständen. Die Unterschiede sind dabei beispielsweise in der Betriebstemperatur des Lasers oder in verschieden gealterten Komponenten des Lasers begründet. Beide Kennlinien weisen jeweils einen vergleichsweise flachen Teil, in dem das vom Laser ausgestrahlte Licht nicht kohärent ist,
und einen steileren Teil auf. Der Laser wird daher im steileren Bereich der Kennlinie mit einem Strom betrieben, der größer als der Schwellstrom für kohärentes Licht. Aus dem Diagramm ist ersichtlich, dass die Ströme, die eine bestimmte Ausgangsleistung des Lasers bewirken, auf verschiedenen Kennlinien jeweils unterschiedlich sind. Da die erste Ausgangsleistung P0 und zweite Ausgangsleistung P1 jedoch konstant bleiben soll, müssen die zugeordneten Ströme entsprechend nachgeführt werden.

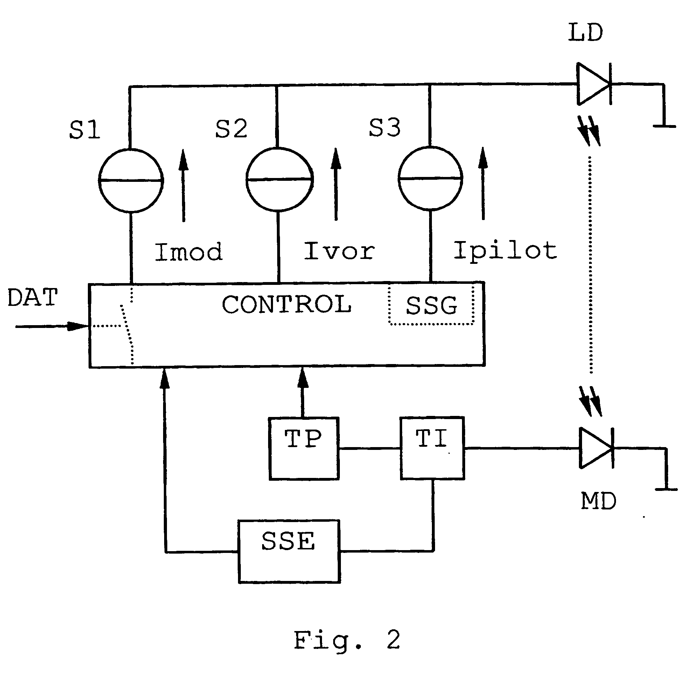

Die Figur 2 zeigt eine beispielhafte Anordnung zur Durchführung des erfindungsgemäßen Verfahrens, bei der eine Steuereinrichtung CONTROL mit einer ersten, einer zweiten und einer dritten Stromquelle S1..S3 verbunden ist und die Steuereinrichtung CONTROL zusätzlich einen Spread-Spectrum-Generator SSG umfasst. Die erste Stromquelle S1 führt einen Modulationsstrom Imod, die zweite Stromquelle S2 einen Vorstrom Ivor und die dritte Stromquelle S3 einen Pilotstrom Ipilot. Die Ausgänge der Stromquellen sind miteinander verbunden und führen zu eine Laserdiode LD, deren n-dotierte Seite mit der elektrischen Masse verbunden ist. Die Laserdiode LD ist optisch mit einer Monitordiode MD verbunden, deren n-dotierter Anschluss ebenfalls mit der elektrischen Masse verbunden ist. Die p-dotierte Seite der Monitordiode führt zu einem Transimpedanzverstärker TI. An den Transimpedanzverstärker TI ist ein Tiefpass TP und ein Spread-Spectrum-Empfänger SSE angeschlossen, wobei die Ausgangssignale jeweils als Eingangssignal für die Steuereinrichtung CONTROL dienen. Weiterhin verfügt die Steuereinrichtung CONTROL über einen Dateneingang DAT. Der Dateneingang DAT ist innerhalb der Steuereinrichtung CONTROL mit der Steuerung für die erste Stromquelle S1 verbunden. Diese Verbindung ist mit einem Schalter symbolisiert.

Die Funktion der in der Figur 2 gezeigten Anordnung ist wie folgt:
Die Laserdiode LD wird durch die erste Stromquelle S1, die zweite Stromquelle S2 und die dritte Stromquelle S3 angesteuert, wobei sich der Modulationsstrom Imod, der Vorstrom Ivor und der Pilotstrom Ipilot überlagern. Alle drei Stromquellen S1..S3 werden von der Steuereinrichtung CONTROL im wesentlichen so angesteuert, dass sich für den Vorstrom Ivor ein Gleichstrom, den Modulationsstrom Imod ein rechteckförmiger Strom und für den Pilotstrom Ipilot beispielsweise ein rechteckförmiger Strom entsprechend einer Pseudorauschsequenz ergibt. Zur Ansteuerung der dritten Stromquelle S3 ist in der Steuereinrichtung CONTROL zusätzlich ein Spread-Spectrum-Generator SSG vorgesehen.

Der Vorstrom Ivor ist so gewählt, dass er größer ist als der Schwellstrom für kohärentes Licht und die erste Ausgangsleistung P0 bewirkt. Dieser Strom ist konstant, sodass die Laserdiode LD jederzeit wenigstens die erste Ausgangsleistung P0 abgibt. Der Modulationsstrom Imod bewirkt in Summe mit dem Vorstrom Ivor die zweite Ausgangsleistung P1 und wird von der Steuereinrichtung CONTROL entsprechend des am Dateneinganges DAT vorliegenden Datenstroms getaktet. Auf diese Weise wird ein binäres Eingangsmuster auf eine Lichtsequenz abgebildet, wobei einer binären Null die erste Ausgangsleistung P0 und einer binären 1 die zweite Ausgangsleistung P1 zugeordnet ist. Der Pilotstrom Ipilot ist so gewählt, dass dessen Amplitude wesentlich kleiner als der Modulationsstrom Imod ist. Das Frequenzspektrum des Pilotstroms Ipilot umfasst dabei einen möglichst großen Bereich, sodass eine Korrelation mit einem diskreten Frequenzwert des Nutzsignals gering ausfällt.

Das von der Laserdiode LD ausgestrahlte Licht wird von einer Monitordiode MD empfangen und in einen Strom umgewandelt. Dieser Strom wird vom Transimpedanzverstärker TI verstärkt und in eine Spannung umgeformt, welche jeweils dem Tiefpass TP und dem Spread-Spectrum-Empfänger SSE zugeführt wird. Der Tiefpass TP erzeugt daraus eine der mittleren Laserausgangsleistung proportionale Gleichspannung, welche der Steuereinrichtung CONTROL als erster Regelparameter dient. Der zweite Regelparameter wird durch den Spread-Spectrum-Empfänger SSE gebildet, welcher eine Gleichspannung liefert, die der Amplitude der durch den Pilotstrom Ipilot verursachten Schwankung der Laserausgangsleistung proportional ist.

Das Auswertung im Spread-Spectrum-Empfänger SSE erfolgt dabei im wesentlichen durch Multiplikation eines dem Pilotstrom Ipilot proportionalem Signals mit dem Ausgangssignal des Transimpedanzverstärkers TI, das dem Strom durch die Monitordiode MD proportional ist. Aufgrund dieser Multiplikation ergeben nur Signalanteile, die mit dem Pilotstrom Ipilot korrelieren, einen wesentlichen Beitrag zu der Gleichspannung am Ausgang des Spread-Spectrum-Empfängers SSE.

Dividiert man diese Gleichspannung durch die Amplitude des Pilotstromes Ipilot, erhält man eine Maßzahl, die unabhängig von der tatsächlichen Höhe des Pilotstroms proportional zur Steigung der Laserkennlinie ist. Da der erste Regelparameter also proportional der mittleren Laserausgangsleistung und der zweite Regelparameter proportional zur Steigung der Laserkennlinie ist, können mit Hilfe der Steuereinrichtung CONTROL die erforderlichen Werte für die Ströme einstellt werden. Die dazu nötigen Proportionalitätskonstanten ergeben sich dabei aus dem Schaltungsaufbau.

Das Signal für den Spread-Spectrum-Generator SSG und den Spread-Spectrum-Empfänger SSE kann zum Beispiel in einfacher Weise aus einem rückgekoppelten Schieberegister erhalten werden. Bekannt sind aber auch zahlreiche andere Verfahren. Siehe dazu auch "Robert C. Dixon, Spread Spectrum Systems, John Willy & Sons, ISBN 0-471-88309-3".

Der modulare Aufbau der Anordnung ist nicht zwingend. Denkbar ist vielmehr auch, dass mehrere Baugruppen zu einer einzigen zusammengefasst werden können. Ein Beispiel hierfür wäre die Integration des Transimpedanzverstärkers TI, des Tiefpass TP und des Spread-Spectrum-Empfängers SSE in die Steuereinrichtung CONTROL. Andererseits ist beispielsweise auch die Verwendung eines separaten Spread-Spectrum-Generator SSG, anstatt des in die Steuereinrichtung CONTROL integrierten, möglich. Das gleiche gilt auch für den Taktgenerator für den Modulationsstrom Imod.

## Patentansprüche

1. Verfahren zur Regelung der Ausgangsleistung modulierter Laser,
- bei dem ein Eingangssignal eines Lasers ein Nutzsignal und ein Pilotsignal umfasst und
- bei dem das Pilotsignal zur Regelung der Ausgangsleistung des Lasers herangezogen wird,
**dadurch gekennzeichnet,**
- **dass** das Frequenzspektrum des Pilotsignals innerhalb des Frequenzbereichs des Nutzsignals weitgehend gleichverteilt ist.

2. Verfahren nach Anspruch 1, **dadurch gekennzeichnet, dass** die Amplitude des Pilotsignals wesentlich kleiner ist, als die Amplitude des Nutzsignals.

3. Verfahren nach einem der Ansprüche 1 bis 2, **dadurch gekennzeichnet, dass** für das Pilotsignal eine digitale Signalfolge vorgesehen ist.

4. Verfahren nach einem der Ansprüche 1 bis 2, **dadurch gekennzeichnet, dass** für das Pilotsignal eine Impulsfolge, insbesondere eine Impulsfolge, bei der die zeitlichen Abstände zwischen den einzelnen Impulsen pseudozufällig verteilt sind, vorgesehen ist.

5. Verfahren nach einem der Ansprüche 1 bis 2, **dadurch gekennzeichnet, dass** für das Pilotsignal ein analoges Signal, insbesondere ein zumindest abschnittsweise sinusförmiges Signal, vorgesehen wird.

6. Verfahren nach Anspruch 5, **dadurch gekennzeichnet, dass** die Frequenz des Pilotsignals fortlaufend variiert wird, insbesondere durch sprungförmige Änderung der Frequenz.

7. Verfahren nach einem der Ansprüche 1 bis 6, **dadurch gekennzeichnet,**
- **dass** aus dem Eingangssignal, insbesondere aus dem Anteil des Nutzsignals, die mittlere Ausgangsleistung des Lasers ermittelt wird,
- **dass** aus dem Eingangssignal, insbesondere aus dem Anteil des Pilotsignals, die Steilheit der Laserkennlinie ermittelt wird und
- **dass** die einem digitalen Wert zugeordnete Ausgangsleistung des Lasers aufgrund der ermittelten mittleren Ausgangsleistung des Lasers und der Steilheit der Laserkennlinie geregelt wird.

8. Anordnung, welche zur Regelung der Ausgangsleistung modulierter Laser gemäß einem Verfahren nach einem der Ansprüche 1 bis 7 vorbereitet ist,
**dadurch gekennzeichnet,**
- **dass** die Anordnung Mittel zur Erzeugung eines Eingangssignals für einen Laser beinhaltet, wobei das Eingangssignal ein Pilotsignal und ein Nutzsignal umfasst,
- **dass** das Frequenzspektrum des Pilotsignals innerhalb des Frequenzbereichs des Nutzsignals weitgehend gleichverteilt ist und
- **dass** die Anordnung Mittel zur Regelung der Ausgangsleistung des Lasers mittels Pilotsignal umfasst.

9. Anordnung nach Anspruch 8, **dadurch gekennzeichnet, dass** für die Erzeugung eines Pilotsignals zumindest ein rückgekoppeltes Schieberegister vorgesehen ist.

10. Anordnung nach einem der Ansprüche 8 bis 9, **dadurch gekennzeichnet,**
- **dass** die Anordnung ein Empfangselement beinhaltet und
- **dass** die Anordnung Mittel zur Demodulation oder Filterung des vom Empfangselement empfangenen Eingangssignals umfasst.

## Claims

1. Method for controlling the output power of modulated lasers,
- in which an input signal of a laser comprises a useful signal and a pilot signal and
- in which the pilot signal is employed for controlling the output power of the laser,
**characterized in that**,
- the frequency spectrum of the pilot signal is largely evenly distributed within the frequency range of the useful signal.

2. Method in accordance with Claim 1, **characterized in that** the amplitude of the pilot signal is significantly lower than the amplitude of the useful signal.

3. Method in accordance with one of the Claims 1 to 2, **characterized in that** the digital signal sequence is provided for the pilot signal.

4. Method in accordance with one of the Claims 1 to 2, **characterized in that** a sequence of pulses, especially a sequence of pulses for which the intervals between the individual pulses are distributed in a pseudo-random way, is provided for the pilot signal.

5. Method in accordance with one of the Claims 1 to 2, **characterized in that** an analog signal, especially a signal for which at least sections are in the form of a sine wave, is provided for the pilot signal.

6. Method in accordance with Claim 5, **characterized in that** the frequency of the pilot signal is continuously varied, especially by abrupt changes to the frequency

7. Method in accordance with one of the Claims 1 to 6,
**characterized in that**
- the mean output power of the laser is determined from the input signal, especially from the component of the useful signal,
- the steepness of the laser characteristic curve is determined from the input signal, especially from the component of the pilot signal, and
- the output power of the laser assigned a digital value is controlled on the basis of the mean output power of the laser determined and the steepness of the laser characteristic curve.

8. Arrangement which is prepared for controlling the output power of modulated lasers using a method in accordance with one of the Claims 1 to 7,
**characterized in that**
- the arrangement includes means for generating an input signal for a laser, with the input signal comprising a pilot signal and a useful signal,
- the frequency spectrum of the pilot signal is largely evenly distributed within the frequency range of the useful signal, and,
- the arrangement includes means for controlling the output power of the laser by means of a pilot signal.

9. Arrangement according to Claim 8, **characterized in that**, for the generation of a pilot signal, at least one closed-loop shift register is provided.

10. Arrangement according to one of the Claims 8 to 9,
**characterized in that**,
- the arrangement contains a receive element and
- the arrangement includes means for demodulation or filtering of the input signal received from the receive element.

## Revendications

1. Procédé de régulation de la puissance de sortie d'un laser modulé,
- dans lequel un signal d'entrée d'un laser comprend un signal utile et un signal pilote, et
- dans lequel on tire parti du signal pilote pour réguler la puissance de sortie du laser,
**caractérisé**
- **en ce que** l'on répartit dans une grande mesure uniformément le spectre de fréquence du signal pilote à l'intérieur du domaine de fréquence du signal utile.

2. Procédé suivant la revendication 1, **caractérisé en ce que** l'amplitude du signal pilote est sensiblement plus petite que l'amplitude du signal utile.

3. Procédé suivant l'une des revendications 1 à 2, **caractérisé en ce que** l'on prévoit une suite numérique de signaux pour le signal pilote.

4. Procédé suivant l'une des revendications 1 à 2, **caractérisé en ce que** l'on prévoit pour le signal pilote un train d'impulsions, notamment un train d'impulsions dans lequel les intervalles dans le temps entre les diverses impulsions sont répartis de manière pseudo-aléatoire.

5. Procédé suivant l'une des revendications 1 à 2, **caractérisé en ce que** l'on prévoit pour le signal pilote un signal analogique, notamment un signal sinusoïdal au moins par parties.

6. Procédé suivant la revendication 5, **caractérisé en ce que** l'on fait varier en continu la fréquence du signal pilote, notamment par des variations par sauts de la fréquence.

7. Procédé suivant l'une des revendications 1 à 6, **caractérisé**
- **en ce que** l'on détermine à partir du signal d'entrée, notamment à partir de la partie du signal utile, la puissance moyenne de sortie du laser,
- **en ce que** l'on détermine à partir du signal d'entrée, notamment à partir de la partie du signal pilote, la raideur de la courbe caractéristique du laser, et
- **en ce que** l'on règle la puissance de sortie du laser associée à une valeur numérique sur la base de la puissance moyenne de sortie du laser qui a été déterminée et de la raideur de la courbe caractéristique du laser qui a été déterminée.

8. Dispositif qui est destiné à la régulation de la puissance de sortie d'un laser modulé suivant un procédé selon l'une des revendications 1 à 7,
**caractérisé**
- **en ce que** le dispositif comprend des moyens de production d'un signal d'entrée pour un laser, le signal d'entrée comprenant un signal pilote et un signal utile,
- **en ce que** le spectre de fréquence du signal pilote est dans une grande mesure réparti uniformément dans le domaine de fréquence du signal utile, et
- **en ce que** le dispositif comprend des moyens de régulation de la puissance de sortie du laser au moyen du signal pilote.

9. Dispositif suivant la revendication 8, **caractérisé en ce que** l'on prévoit pour la production d'un signal pilote au moins un registre à décalage rétrocouplé.

10. Dispositif suivant l'une des revendications 8 à 9, **caractérisé**
- **en ce que** le dispositif comporte un élément de réception, et
- **en ce que** le dispositif comporte des moyens de démodulation ou de filtrage du signal d'entrée reçu par l'élément de réception.
